# EUROPEAN PATENT SPECIFICATION

(11) **EP 3 383 158 B1**
(45) Date of publication and mention of the grant of the patent: **23.06.2021**
(21) Application number: 15909318.6
(22) Date of filing: 27.11.2015
(51) Int. Cl.: H05K 13/04, B25J 15/04, H05K 13/08, B25J 15/06

(54) **WORK DEVICE**
ARBEITSVORRICHTUNG
DISPOSITIF DE TRAVAIL

(43) Date of publication of application: 03.10.2018
(73) Proprietor: Fuji Corporation, Chiryu-shi, Aichi 472-8686 (JP)
(72) Inventor: OKA, Hiromitsu, Chiryu Aichi (JP); TESHIMA, Chikashi, Chiryu Aichi (JP)
(74) Representative: Grünecker Patent- und Rechtsanwälte PartG mbB
(86) International application number: PCT/JP2015/083468
(87) International publication number: WO 2017/090201

(56) References cited:
- JP-B2- 2 857 673
- JP-B2- 5 054 245
- JP-B2- 5 637 734
- JP-B2- 5 813 210
- US-A1- 2006 085 973
- US-A1- 2006 207 090
- None

## Description

### Technical Field

The present invention relates to a system comprising a work device and different types of work heads according to claim 1.

### Background Art

For example, disclosed in patent literature 1 as a work machine is a component mounter provided with a work head that picks up a supplied component using air pressure (vacuum pressure), moves the picked up component and mounts it on a board. The work head is configured to be exchangeable to handle different types of components. A system comprising a work device and different types of work heads according to the preamble of claim 1 is disclosed in patent literature 2 and 3.

### Citation List

### Patent Literature

Patent literature 1: JP2004-221518
Patent literature 2: US 2006/207090 A1
Patent literature 3: JP 5 813210 B2

### Summary of Invention

### Technical Problem

With recent component mounters, to improve production efficiency, there is a trend to load compact work heads designed to transport components more quickly. However, with a compact work head, because it is necessary to run air paths in a small space within the head almost like a mesh, the diameter of each air path must be made extremely small. With such a work head, because the air flow amount is greatly restricted, when air leaks occur between the suction nozzle and the component being picked up due to the uneven surface of the component or the like, the vacuum pressure at the nozzle tip drops, and the holding power of the component at the nozzle drops. In such a case, if the component is heavy, it is necessary to lower the component transport speed such that the component does not drop while being moved. Also, depending on the component weight, there may be cases in which it is not possible to pick up the component.

The present invention takes account of such circumstances, and an object thereof is to provide a work device on which it is possible to load compact work heads with different air flow amounts.

### Solution to Problem

To solve the above problems, the system of the present invention includes a work device with:
a device main body provided with a first air path and a second air path that are configured to be connected to different types of work heads, the work heads being configured to be exchangeable and to perform specified work using air pressure. The technical problem is solved by the features of claim 1.

Accordingly, by making the second air path have a larger capacity than, for example, the normal flow capacity of the first air path, in the work device, it is possible to use both a compact work head that uses a normal air flow amount, and a compact work head that uses a flow amount larger than the normal amount.

### Brief Description of Drawings

Fig. 1

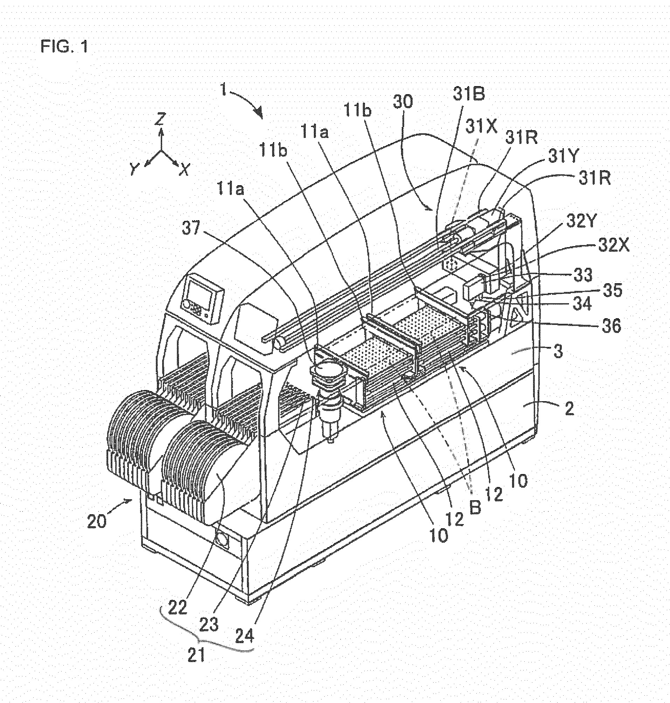

   Fig. 1 is a perspective view of a component mounter, which is a work device of an embodiment of the present invention.
Fig. 2A

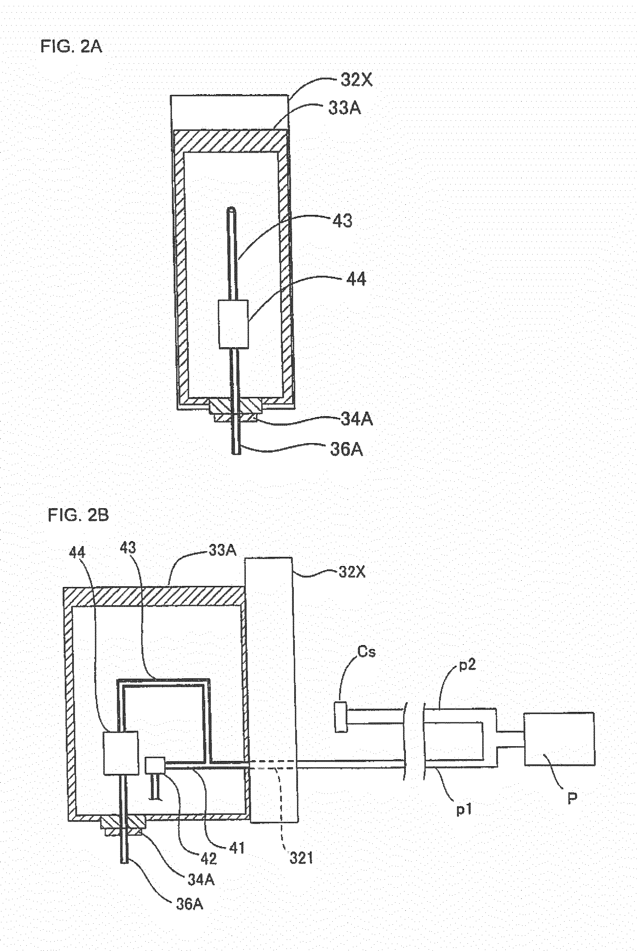

   Fig. 2A is a front view cross section of a first work head that is loaded on the component mounter.
Fig. 2B
   Fig. 2B is a side view cross section of the first work head of fig. 2A.
Fig. 3A

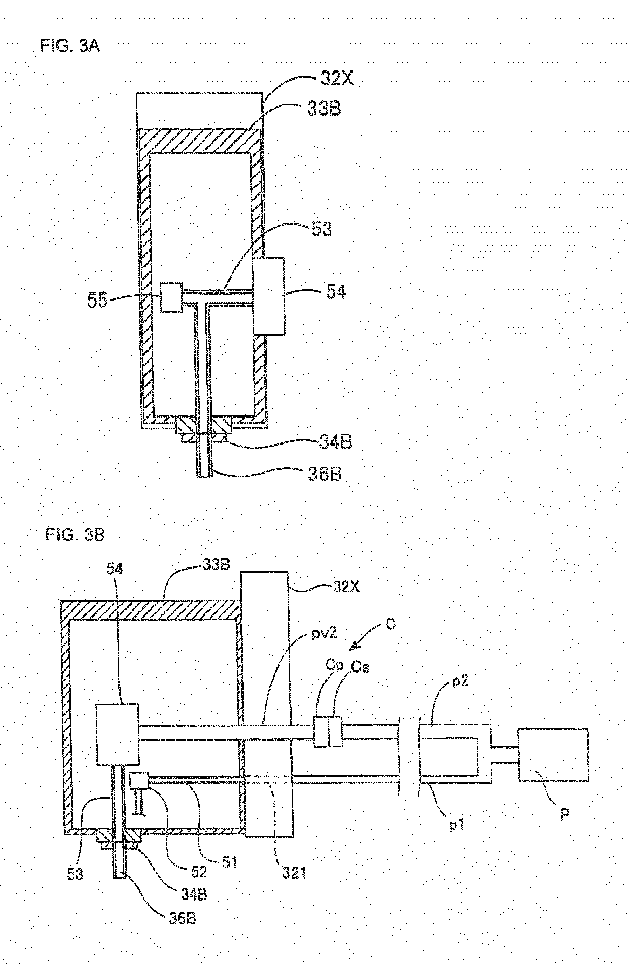

   Fig. 3A is a front view cross section of a second work head that is loaded on the component mounter.
Fig. 3B
   Fig. 3B is a side view cross section of the second work head of fig. 3A.
Fig. 4

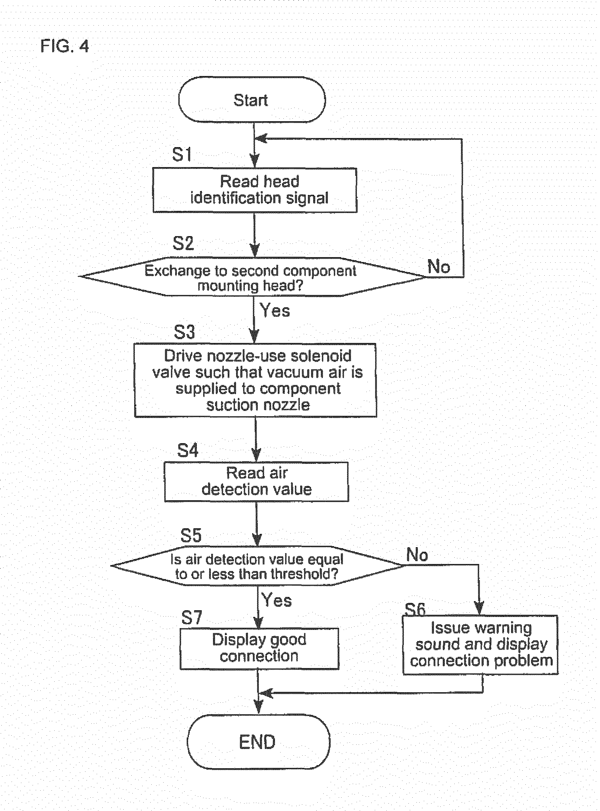

   Fig. 4 is a flowchart for illustrating operation of the component mounter during head exchange.

### Description of Embodiments

### 1. Configuration of work device

An overview of the configuration of a component mounter, which is an embodiment of the work device of the present invention, is described with reference to fig. 1. Note that, fig. 1 shows a state in which two component mounters 1 are loaded on one base 2, but there are cases in which there is only one component mounter 1 in a production line, and cases in which there are multiple component mounters 1 lined up side by side in a production line. In the descriptions below, the direction in which the two component mounters 1 are lined up, that is, the conveyance direction of board B, is the X-axis direction, the direction perpendicular to the X-axis direction in a horizontal plane is the Y-axis direction, and the direction perpendicular to the X-axis direction and the Y-axis direction is the Z-axis direction.

As shown in fig. 1, component mounter 1 is provided with items including: board conveyance device 10, which conveys board B, disposed at a rear side (right side of fig. 1) of mounter main body 3; component supply device 20, which supplies components to be mounted on board B, disposed at a front side (left side in fig. 1) of mounter main body 3; and component transfer device 30, which picks up and transports components supplied by component supply device 20 and mounts them on board B conveyed by board conveyance device 10, disposed above both devices 10 and 20.

In board conveyance device 10, board B is conveyed to a component mounting position by a pair of conveyor belts, not shown, while being guided in the Y direction by a pair of guide rails 11a and 11b, and is positioned and fixed by being raised from the conveyor belts and clamped by clamp device 12. In component supply device 20, component packaging tape is fed by a specified pitch from supply reel 22 by the rotation of a sprocket, not shown, provided in tape feeder 21. Also, top tape of the component packaging tape is peeled by tape peeling device, such that exposed components are sequentially fed to component supply section 24.

Component transfer device 30 is an XY robot attached to an upper section of mounter main body 3 and arranged above board conveyance device 10 and component supply device 20. Component transfer device 30 is provided with items such as: Y-axis slider 32 that is moved in the Y-axis direction along rail 31R by Y-axis servo motor 31Y via ball screw 31B; and X-axis slider 32X ("head attachment base" of the present invention) that is moved in the X-axis direction by X-axis servo motor 31X via a ball screw that is not shown. X-axis slider 32X is arranged on Y-axis slider 32Y to be movable in the X-axis direction. Work head 33 that mounts components on board B is loaded on X-axis slider 32.

Nozzle holder section 34 that has on a lower section component suction nozzle 36 that protrudes downwards and picks up and holds components, and board imaging camera 35 that images board B positioned and fixed at the component mounting position, are attached to work head 33. Nozzle holder section 34 is able to be raised and lowered in the Z-axis direction by a servo motor, not shown, provided on work head 33, and to be rotated around the Z-axis. Component suction nozzle 36 is connected to vacuum pump P (refer to fig. 2B) as an air source such that components can be picked up by suction at the tip of the nozzle. Also, component imaging camera 37 that images components picked up and held by component suction nozzle 36 is provided between board conveyance device 10 and component supply device 20.

With component transfer device 30, components supplied to component supply section 24 are picked up and held by component suction nozzle 36. Then, the component is moved above component imaging camera 37, image recognition is performed, and the component orientation is corrected. Further, the component is moved above the board B positioned and fixed at the component mounting position, and mounted at a specified mounting position on board B.

Here, as described in the background art, work head 33 is compact to move components at high speed and improve production efficiency. However, because it is necessary to run air paths in a small space within the head almost like mesh, the diameter of a single air path is small, and it is difficult to pick up and transport heavy components. Thus, component transfer device 30 is configured such that two types of work heads work head 33 (also referred to as first work head 33A and second work head 33B) are exchangeable, as described in detail below.

### 2. Configuration of work heads

First work head 33A is a conventional head capable of picking up relatively light components, while second work head 33B is a new head capable of picking up relatively heavy components. The configurations of first work head 33A and second work head 33B are described below with reference to figs. 2A and 2B and figs. 3A and 3B. Note that, only configurations related to air are shown in the figures, configurations related to other items such as component imaging camera 37 are omitted.

As shown in figs. 2B and 3B, first and second work heads 33A and 33B are configured to be removably attached (exchangeable) to X-axis slider 32X using a positioning and fixing device that is not shown. Provided on X-axis slider 32X is intermediate air path 321 (corresponding to "first air path" of the present invention) connected to nozzle-use air path 41 (corresponding to "first air path" of present invention) inside first work head 33A or nozzle-use air path 51 (corresponding to "first air path" of the present invention) inside second work head 33B when first work head 33A or second work head 33B is positioned and fixed by the positioning and fixing device.

Intermediate air path 321 is fixedly connected to first air pipe p1 (corresponding to "first air path" of the present invention) that extends from vacuum pump P. First air pipe p1 is a pipe that divides near vacuum pump P, and the other pipe of the divide near vacuum pump P is connected to socket Cs of coupling C as second air pipe p2 (corresponding to "second air path" of the present invention) that extends to near X-axis slider 32X. The pipe diameter of second air pipe p2 is larger than the pipe diameter of first air pipe p1.

As shown in figs. 2A and 2B, nozzle-use air path 41 capable of being connected to intermediate air path 321 of X-axis slider 32X is provided inside first work head 33A. Nozzle-use air path 41 is connected to nozzle holder section 34A via holder-use solenoid valve 42 to be used for picking up and holding nozzle holder section 34A (including component suction nozzle 36A) on first work head 33A. Note that, nozzle-use air path 41 from holder-use solenoid valve 42 to nozzle holder section 34A, and a device for detecting air pressure inside nozzle-use air path 41, are omitted from fig. 2B.

Also, nozzle-use air path 41 divides at an intermediate point into light-component-use air path 43. Light-component-use air path 43 is connected to component suction nozzle 36A via nozzle-use solenoid valve 44 to be used for picking up a light component using component suction nozzle 36A. Note that, a device for detecting air pressure inside light-component-use air path 43 provided between nozzle-use solenoid valve 44 and component suction nozzle 36A is omitted from fig. 2B.

As described above, the pipe diameter of first air pipe p1 extending from vacuum pump P is smaller than the pipe diameter of second air pipe p2, and the diameters of intermediate air path 321 connected to first air pipe p1, light-component-use air path 43, and component suction nozzle 36A are the same as the pipe diameter of first air pipe p1. Thus, components picked up by component suction nozzle 36A are limited to relatively light components.

As shown in figs. 3A and 3B, nozzle-use air path 51 capable of being connected to intermediate air path 321 of X-axis slider 32X is provided inside second work head 33A. Nozzle-use air path 51 is connected to nozzle holder section 34B via holder-use solenoid valve 52 to be used for picking up and holding nozzle holder section 34B (including component suction nozzle 36B) on second work head 33A.

Nozzle-use air path 51 is dedicated for picking and holding nozzle-holder section 34B, and differs from nozzle-use air path 41 of first head 33A in that it is not divided at any point. Note that, nozzle-use air path 51 from holder-use solenoid valve 52 to nozzle holder section 34B, and a device for detecting air pressure inside nozzle-use air path 51, are omitted from fig. 3B. Also, nozzle-use solenoid valve 54 with a larger capacity than nozzle-use solenoid valve 44 of first work head 33A is provided on an external portion of second work head 33B.

Valve-side second air pipe pv2 (corresponding to "second air path" of the present invention") provided with plug Cp capable of being connected to socket Cs of coupling C of second air pipe p2 is connected to this external port of nozzle-use solenoid valve 54. Heavy-component-use air path 53 is connected to the inside port of nozzle-use solenoid valve 54. Heavy-component-use air path 53 is connected to component suction nozzle 36B via nozzle-use solenoid valve 54, which has a larger capacity than nozzle-use solenoid valve 44 of first work head 33A, to be used for picking up a heavy component using suction nozzle 36B.

As described above, the pipe diameter of second air pipe p2 extending from vacuum pump P is larger than the pipe diameter of first air pipe p1, and the diameters of valve-side second air pipe pv2 connected to second air path p2, heavy-component-use air path 53, and component suction nozzle 36B are the same as the pipe diameter of second air pipe p2. In other words, second work head 33B has a greatly improved air flow amount while curtailing an increase in the size of the head by only increasing the end portion of large-component-use air path 53. Accordingly, it is possible to pick up relatively heavy components with component suction nozzle 36B.

Further, air state detecting device 55 that detects air pressure inside the air path is connected to large-component-use air path 53. Because valve-side second air pipe pv2 is required for connecting to second air path p2 via coupling C, component mounter 1 is able to determine whether there is a problem with the connection state of coupling C, valve-side second air pipe pv2, or the like, that is, a connection state of component suction nozzle 36B and vacuum pump P, based on an air pressure detection value of air state detecting device 55. By this, it is possible to prevent component pickup errors and lost production time.

### 3. Operation of component mounter during head exchange

Next, operation of component mounter 1 when an operator exchanges first work head 33A attached to X-axis slider 32X of component mounter 1 with second work head 33B is described with reference to the flowchart of fig. 4. First, the operator removes first work head 33A from X-axis slider 32X, then positions and fixes second work head 33B to X-axis slider 32X using the positioning and fixing device. By this, nozzle-use air path 51 inside second work head 33B is connected to first air pipe p1 via intermediate air path 321. Next, the operator connects socket Cs of coupling C of second air pipe p2 and plug Cp of coupling C of valve-side second air pipe pv2. By this, large-component-use air path 53 inside second work head 33B is connected to second air pipe p2 via coupling C.

Component mounter 1 reads a head identification signal from second work head 33B loaded on X-axis slider 32X (step S1 of fig. 4), and determines whether first work head 33A has been exchanged for second work head 33B, based on the read head identification signal (step S2 of fig. 4). Component mounter 1, upon determining that first work head 33A has been exchanged for second work head 33B (when step S2 of fig. 4 is "Yes"), drives nozzle-use solenoid valve 54 such that vacuum air is supplied to component suction nozzle 36B (step S3 of fig. 4). Then, component mounter 1 reads an air pressure detection value from air state detecting device 55 (step S4 of fig. 4), and determines whether the read air pressure detection value is equal to or less than a specified air pressure threshold value (vacuum pressure limit at which component pickup is possible) (step S5 of fig. 4).

Component mounter 1, if determining that the air pressure detection value is not equal to or less than the specified air pressure threshold value (step S5 in fig. 4 is "No"), determines that there is a problem with the connection between valve-side second air pipe pv2 of second work head 33B and vacuum pump P, issues a warning sound of the connection problem from a speaker, and displays an indication of the connection problem on a display device (step S6 of fig. 4). On the other hand, if component mounter 1 determines that the air pressure detection value is equal to or less the specified air pressure threshold value (step S5 of fig. 4 is "Yes"), component mounter 1 displays an indication that the connection is good on the display device (step S7 of fig. 4). Then, component mounter 1 starts component mounting operation with respect to the board. Note that, component mounter 1 may detect whether component pickup has occurred, or whether there is a problem with the pickup state such as a tombstoned component based on the air pressure detection value read from air state detecting device 55.

### 4. Effects

Component mounter 1 of the present embodiment includes: a device main body provided with first air paths p1, 321, 41, and 51, and second air paths p2, pv2, and 53 that are configured to be connected to different types of work heads, 33A and 33B, wherein the work heads are configured to be exchangeable and to perform specified work using air pressure. Accordingly, by making the second air path p2, pv2, and 53 have a larger capacity than, for example, the normal flow capacity of the first air path p1, 321, 41, and 51, in component mounter 1, it is possible to use both compact work head 33A that uses a normal air flow amount, and compact work head 33B that uses a flow amount larger than the normal amount.

Also, first air paths p1, 321, 41, and 51 are provided to run via head attachment base (X-axis slider) 32X to which work head 33A and 33B are attached, and second air paths p2, pv2, and 53 are provided not to run via head attachment base 32X, therefore, for example, in a case in which the path diameter of, for example, second air path p2, pv2, and 53 is made larger than the path diameter of first air path p1, 321, 41, and 51, work head 33B to be connected to second air paths p2, pv2, and 53 can have a large air flow while maintaining a compact size.

Also, air state detecting device 55 that detects an air state of second air path p2, pv2, and 53 is provided in second air path p2, pv2, and 53, and a connection state between work head 33B and second air path p2, pv2, and 53 is determined based on a detection value of air state detecting device 55, therefore, even if second air path p2, pv2, and 53 are provided not to run via head attachment base 32X, work head 33B connected to second air path p2, pv2, and 53 can operate reliably.

Also, because an operating state of work head 33B is determined based on a detection value of air state detecting device 55, operation accuracy of work head 33B is improved. Further, work heads 33A and 33B that are different types are first work head 33A and second work head 33B, first work head 33A being connected to first air path p1, 321, and 41, and second work head 33B being connected to first and second air paths p1, 321, and 51, and p2, pv2, and 53, therefore, even in a case in which, for example, the path diameter of second air path p2, pv2, and 53 is larger than the path diameter of first air path p1, 321, and 51, a large and small air flow amount can be used at second work head 33B.

Also, first and second work heads 33A and 33B are heads that pick up and transport a component using nozzle (component suction nozzle) 36A or 36B; the work device is component mounter 1 that mounts the component picked up by nozzle 36A and 36B on board B; second air path p2, pv2, and 53 is provided to allow a greater volume of air than that of first air path p1, 321, 41, and 51; first work head 33A picks up a component and holds nozzle 36A using air pressure of first air path p1, 321, and 41; and second work head 33B picks up a component using air pressure of second air path p2, pv2, and 53, and holds nozzle 36B using air pressure of first air path p1, 321, and 51. Thus, component mounter 1 is able to pick up components reliably even if the component picked up by second work head 33B is heavy, and can operate at a high component transport speed, thus greatly improving production efficiency.

Further, first and second air paths p1, 321, 41, and 51, and p2, pv2, and 53 are connected to a single air source P, and are divided near to air source P, therefore, it is possible to maintain a constant air pressure inside first and second air paths p1, 321,41, and 51, and p2, pv2, and 53.

### 5. Other

An embodiment above was described using component mounter 1 as a work device, but the present invention may be applied to any work device for which exchange is possible of different types of work heads that perform specified work using air pressure. Also, second work head 33B is provided with air state detecting device 55 that detects air pressure, but this item is not limited to a device that detects air pressure, so long as an air state of heavy-component-use air path 53 can be recognized, for example, a device that detects an air flow may be connected to heavy-component-use air path 53. Further, second work head 33B may use only second air path p2, pv2, and 53 without using first air path p1, 321, and 51. Also, first and second work heads 33A and 33B may hold component suction nozzle 41 and 51 via, for example, a pin, and are not limited to holding these by air pressure.

### Reference Signs List

1: component mounter; 10: board conveyance device; 20: component supply device; 30: component transfer device; 32X: X-axis slider; 321: intermediate air path; 33A: first work head; 33B: second work head; 34A, 34B: nozzle holder section; 36A, 36B: component suction nozzle; 41, 51: nozzle-use air path; 42, 52: holder-use solenoid valve; 43: light-component-use air path; 53: heavy-component-use air path; 44, 54: nozzle-use solenoid valve; 55: air state detecting device; p1: first air pipe; p2: second air pipe; pv2: valve-side second air pipe; C: coupling; Cs: socket; Cp: plug

## Claims

1. A system comprising a work device (1) and different types of work heads (33A, 33B) comprising:
a device main body provided with a first air path (p1, 321, 41, 51) and a second air path (p2, pv2, 53) that are configured to be connected to the different types of work heads (33A, 33B), the work heads (33A, 33B) being a first (33A) and a second work head (33B) each configured to pick up and transport a component using a nozzle (36A, 36B), and configured to be exchangeable and to perform specified work using air pressure, wherein
the work device (1) is configured to mount the component picked up by the nozzle (36A, 36B) on a board, and
the first work head (33A) is configured to be connected with only the first air path (p1, 321, 41, 51), and the second work head (33B) is configured to be connected to at least the second air path (p2, pv2, 53)
**the system is characterized in that:**
the second air path (p2, pv2, 53) is provided to allow a greater volume of air than that of the first air path (p1, 321, 41, 51),
the first work head (33A) is configured to pick up the component and to hold the nozzle (36A, 36B) using air pressure of the first air path (p1, 321, 41, 51), and
the second work head (33B) is configured to pick up the component using air pressure of the second air path (p2, pv2, 53).

2. The work device (1) according to claim 1, wherein
the first air path (p1, 321, 41, 51) is provided via a head attachment base (32X) to which the work head (33A, 33B) is attached, and
the second air path (p2, pv2, 53) is provided not via the head attachment base (32X).

3. The work device (1) according to claim 2, wherein
an air state detecting device (55) configured to detect an air state of the second air path (p2, pv2, 53) is provided on the second air path (p2, pv2, 53), and a connection state between the work head (33A, 33B) and the second air path (p2, pv2, 53) is determined based on a detection value of the air state detecting device (55).

4. The work device (1) according to claim 3, wherein
a work state of the work head (33A, 33B) is determined based on the detection value of the air state detecting device (55).

5. The work device (1) of any one of the claims 1 to 4, wherein
the first and second air paths (p2, pv2, 53) are connected to a single air source, and are divided near to the air source.

## Patentansprüche

1. Ein System, umfassend eine Arbeitsvorrichtung (1) und verschiedene Arten von Arbeitsköpfen (33A, 33B), umfassend:
einen Vorrichtungshauptkörper, der mit einem ersten Luftweg (p1, 321, 41, 51) und einem zweiten Luftweg (p2, pv2, 53) versehen ist, die konfiguriert sind, um mit den verschiedenen Arten von Arbeitsköpfen (33A, 33B) verbunden zu werden; die Arbeitsköpfe (33A, 33B) ein erster (33A) und ein zweiter Arbeitskopf (33B) sind, die jeweils zum Aufnehmen und Transportieren eines Bauteils unter Verwendung einer Düse (36A, 36B) konfiguriert sind und so konfiguriert sind, dass sie austauschbar sind und unter Verwendung von Luftdruck bestimmte Arbeiten ausführen, wobei
das Arbeitsgerät (1) so konfiguriert ist, dass es die von der Düse (36A, 36B) aufgenommene Komponente auf einer Platine montiert,
der erste Arbeitskopf (33A) ist so konfiguriert, dass er nur mit dem ersten Luftweg (p1, 321, 41, 51) verbunden ist, und der zweite Arbeitskopf (33B) ist so konfiguriert, dass er mindestens mit dem zweiten Luftweg (p2, pv2, 53) verbunden ist,
**das System gekennzeichnet ist dadurch dass:**
der zweite Luftweg (p2, pv2, 53) angeordnet ist, um ein größeres Luftvolumen zu ermöglichen als das des ersten Luftweges (p1, 321, 41, 51),
der erste Arbeitskopf (33A) konfiguriert ist, um das Bauteil aufzunehmen und die Düse (36A, 36B) unter Verwendung des Luftdrucks des ersten Luftwegs (p1, 321, 41, 51) zu halten, und
der zweite Arbeitskopf (33B) konfiguriert ist, um die Komponente unter Verwendung des Luftdrucks des zweiten Luftpfades (p2, pv2, 53) aufzunehmen.

2. Die Arbeitsvorrichtung (1) gemäß Anspruch 1, wobei
der erste Luftweg (p1, 321, 41, 51) über eine Kopfbefestigungsbasis (32X) bereitgestellt wird, an welcher der Arbeitskopf (33A, 33B) angebracht ist, und
der zweite Luftweg (p2, pv2, 53) nicht über die Kopfbefestigungsbasis (32X) bereitgestellt wird.

3. Die Arbeitsvorrichtung (1) gemäß Anspruch 2, wobei
auf dem zweiten Luftweg (p2, pv2, 53) eine Luftzustandserfassungsvorrichtung (55) angeordnet ist, die konfiguriert ist, um einen Luftzustand des zweiten Luftwegs (p2, pv2, 53) zu erfassen, und ein Verbindungszustand zwischen dem Arbeitskopf (33A, 33B) und dem zweiten Luftweg (p2, pv2, 53) basierend auf einem Erfassungswert der Luftzustandserfassungsvorrichtung (55) bestimmt wird.

4. Die Arbeitsvorrichtung (1) gemäß Anspruch 3, wobei
ein Arbeitszustand des Arbeitskopfes (33A, 33B) basierend auf dem Erfassungswert der Luftzustandserfassungsvorrichtung (55) bestimmt wird.

5. Die Arbeitsvorrichtung (1) gemäß einem der Ansprüche 1 bis 4, wobei
der erste und der zweite Luftweg (p2, pv2, 53) mit einer einzelnen Luftquelle verbunden sind und in der Nähe der Luftquelle aufgeteilt werden.

## Revendications

1. Système comprenant un dispositif de travail (1) et différents types de têtes de travail (33A, 33B) comprenant :
un corps principal de dispositif doté d'un premier circuit d'air (p1, 321, 41, 51) et d'un deuxième circuit d'air (p2, pv2, 53) qui sont configurés pour être connectés aux différents types de têtes de travail (33A, 33B), les têtes de travail (33A, 33B) étant une première (33A) et une deuxième (33B) têtes de travail chacune configurée pour prélever et acheminer un composant en utilisant une buse (36A, 36B), et configurée pour être échangeable et pour exécuter une tâche spécifiée en utilisant une pression d'air, dans lequel
le dispositif de travail (1) est configuré pour monter le composant prélevé par la buse (36A, 36B) sur une carte, et
la première tête de travail (33A) est configurée pour être connectée à uniquement le premier circuit d'air (p1, 321, 41, 51), et la deuxième tête de travail (33B) est configurée pour être connectée à au moins le deuxième circuit d'air (p2, pv2, 53)
**le système est caractérisé en ce que** :
le deuxième circuit d'air (p2, pv2, 53) est disposé pour autoriser un volume d'air supérieur à celui du premier circuit d'air (P1, 321, 41, 51),
la première tête de travail (33A) est configurée pour prélever le composant et pour maintenir la buse (36A, 36B) en utilisant une pression d'air du premier circuit d'air (P1, 321, 41, 51), et
la deuxième tête de travail (33B) est configurée pour prélever le composant en utilisant une pression d'air du deuxième circuit d'air (p2, pv2, 53).

2. Le dispositif de travail (1) de la revendication 1, dans lequel
le premier circuit d'air (p1, 321, 41, 51) est acheminé en passant par une base de rattachement de tête (32X) à laquelle la tête de travail (33A, 33B) est rattachée, et
le deuxième circuit d'air (p2, pv2, 53) est acheminé sans passer par la base de rattachement de tête (32X).

3. Le dispositif de travail (1) selon la revendication 2, dans lequel
un dispositif de détection d'état d'air (55) configuré pour détecter un état d'air du deuxième circuit d'air (p2, pv2, 53) est disposé sur le deuxième circuit d'air (p2, pv2, 53), et un état de connexion entre la tête de travail (33A, 33B) et le deuxième circuit d'air (p2, pv2, 53) est déterminé selon une valeur de détection du dispositif de détection d'état d'air (55).

4. Le dispositif de travail (1) selon la revendication 3, dans lequel
un état de travail de la tête de travail (33A, 33B) est déterminé selon la valeur de détection du dispositif de détection d'état d'air (55).

5. Le dispositif de travail (1) de l'une quelconque des revendications 1 à 4, dans lequel
les premier et deuxième circuits d'air (p2, pv2, 53) sont connectés à une source d'air unique, et sont divisés près de la source d'air.
